# EUROPEAN PATENT SPECIFICATION

(11) **EP 0 426 665 B1**
(45) Date of publication and mention of the grant of the patent: **27.10.1993**
(21) Application number: 88908896.9
(22) Date of filing: 02.09.1988
(51) Int. Cl.: H05K 3/46, H05K 3/40, H05K 3/20

(54) **METHOD FOR MANUFACTURING PRINTED CIRCUIT BOARDS**
VERFAHREN ZUR HERSTELLUNG VON LEITERPLATTEN
PROCEDE POUR LA FABRICATION DE CARTES DE CIRCUITS IMPRIMES

(43) Date of publication of application: 15.05.1991
(73) Proprietor: WESTINGHOUSE ELECTRIC CORPORATION, Pittsburgh Pennsylvania 15222 (US)
(72) Inventor: KING, David, R., Merion Station, PA 19066 (US); LEE, Mark, S., Columbia, MD 21046 (US); DECKER, Richard, W., Baltimore, MD 21228 (US)
(74) Representative: van Berlyn, Ronald Gilbert
(86) International application number: US8803102
(87) International publication number: WO9003100

(56) References cited:
- US-A- 3 181 986
- US-A- 3 913 223
- US-A- 3 953 924
- US-A- 4 769 309
- IBM TECHNICAL DISCLOSURE BULLETIN, vol. 11, no. 12, May 1969, (New York, US), K.F. Greene: "Producing printed circuit boards", pages 1676-1677
- IBM TECHNICAL DISCLOSURE BULLETIN, vol. 20, no. 9, February 1978, (New York, US); J.G. Cutillo et al.: "High resolution circuitization process", pages 3389-3390

## Description

This invention relates to a method for fabricating a multilayer printed circuit board.

State of the art printed circuit and wiring boards are requiring smaller and smaller circuitry. The present subtractive and semi-additive processes, though they can in many cases meet the needs of the industry today, are rapidly being pushed to the limit of their capability to provide the fine circuitry features required. Tighter controls are needed to even attempt fine line boards, and yields drop off dramatically as the lines and spaces get smaller.

In conventional printed wiring technology, circuitry is fabricated in layer pairs, with a layer of circuitry being disposed on either side of a sheet of dielectric material. The layer pairs are laminated together and drilled and plated to make the completed multilayer structure. The conventional method of etching back copper clad dielectric material to produce circuitry has proved to be inadequate when dealing with extremely fine lines. A major problem with this prior art method is the undercutting that accompanies the etching of the copper cladding. Etching the sides of the circuitry decreases the line width in such a way that the circuitry does not always have straight sides. The etching is also not completely uniform, so that some lines will have more of their sides etched away than other lines. The tolerances that are inherent with the etching process are not good enough to meet the very large scale integrated circuit requirements.

Another problem in the prior art fabrication of printed circuit and wiring boards concerns the method of making interconnections between the various layers of a multilayer board. This prior method involves drilling holes through copper and board material, and then plating copper through the hole to make the electrical connection. Because of problems associated with attempting this copper plating process, a good percentage of failures of printed wiring boards are related to the plated through holes. Furthermore, in order to accommodate this method of interconnecting, the art work utilized in fabricating the boards is designed with pads at the hole locations. These pads must be several times larger than the circuitry in order to provide a big enough target for the drill. The density of the circuitry, therefore, is limited because of the large pads that must be worked around.

United States Patent No. 4,606,787, issued August 19, 1986 and entitled "Method and Apparatus for Manufacturing Multilayer Printed Circuit Boards", describes a method by which printed circuit boards are fabricated using an additive process for creating the conductive lines on the board. This method eliminates the etching difficulties, but still retains the hole plating procedure for providing interlayer circuit connections.

IBM Technical Disclosure Bulletin, Volume 11 No. 12, May 1969, (New York, US) by K. F. Greene titled "Producing Printed Circuit Boards", Pages 1676-1677 discusses a method for producing multilayer printed wiring boards by securing separate single layers to form the desired multilayer design. Each individual layer must be aligned and secured to the adjacent layer. Also the IBM disclosure teaches the deposition of an insulating material, curing the material and then grinding the excess material to expose circuitry. A method is desired whereby an additive process is used to fabricate a multilayer printed circuit board and the need to selectively remove laminate by grinding is eliminated.

United States Patent 3,913,223 by Gigoux issued October 21, 1975 titled "Method of Manufacturing a Double-sided Circuit" discusses a method for manufacturing a double-sided circuit to form a multilayer structure. However Gigoux teaches the use of a mechanical clamping system to secure adjacent circuit layers. Gigoux also teaches the use of a film of a low melting point placed between adjacent circuit layers such that the film may be melted and cooled to integrally attach the layers of circuit patterns. A method is desired which avoids the need for mechanical clamping and the need for a single bonding layer.

Another disadvantage of the prior art fabrication of printed wiring boards concerns the pads utilized for the attachments of the very large scale integrated (VLSI) circuit packages which are to be mounted on the boards. In particular, the solder deposition and lead separation of high density VLSI printed wire assemblies has been a difficult task. Solder masks have been investigated; however, many are difficult to process, are unable to withstand extreme environmental conditions, and are not able to be fabricated to the applicable size requirements.

One common method of surface mounting the VLSI component assemblies on the boards includes soldering the leads of the components to pads on the board. On boards with a large number of pads, it is necessary to find an alternate method of soldering the leads individually. If enough solder is located at each pad, the board can be heated using a vapor phase or comparable process and all the component leads can be soldered simultaneously. Though there exists several methods for placing the solder on the pads, there exists a problem with dense circuitry, for unless the solder is contained, it can flow between the pads and form solder bridges. There bridges then short circuit the board, rendering it useless.

The present invention consists in a method for fabricating a multilayer printed circuit board comprising the steps of:
a) providing a first board panel having a uniform first layer of conductive material and a raised electrically conducting first circuit pattern extending from the first layer of conductive material, the first layer of conductive material having structural reinforcement such that the first circuit pattern may be deposited directly upon the first layer surface, and the first layer further of a conductive material different than that of the circuit pattern, such that a selected etchant will attack only the first conductive layer material;
b) providing a second board panel having a uniform second layer of conductive material and a raised electrically conducting second circuit pattern extending from the second layer of conductive material and a raised electrically conducting third circuit pattern extending from said second circuit pattern, the second layer of conductive material having structural reinforcement such that the second circuit pattern may be deposited directly upon the second layer surface, and the second layer further of a conductive material different than that of the circuit pattern, such that a selected etchant will attack only the second layer material;
c) uniting a plurality of conductive circuit pattern assembly board panels while cavernous fill-laminating said first board panel matched to said second board panel with a laminate insulating material being the filling disposed in the caverns or cavities formed therebetween and thereby electrically insulating said first circuit pattern from said second circuit pattern and with said third circuit pattern electrically contacting said first circuit pattern at selected portions thereof; and then
d) etching away said first and second layers of conductive material from said laminate insulating material and away from said first and second circuit patterns.

One method for fabricating the top board panel of the printed circuit board to provide for recessed component mounting pads includes as the first step the fabrication of a member having a raised conductive circuit pattern extending from a first, or base, layer of conductive material which may be disposed on a substrate or extending from the substrate itself which may, if electrically conductive, act as the first layer of conductive material. The raised conductive circuit pattern on the first conductive layer is embedded within a laminate insulating material having a thickness greater than the height of the raised circuit pattern. A hole is drilled through the laminate insulating material to expose the circuit pattern at those selected positions where the component mounting pads are to be located. A second layer of conductive material is deposited upon the exposed surfaces of the circuit pattern to a thickness less than the thickness of the insulating material above the circuit pattern.

The first, or base, layer of conductive material is removed from both the laminate insulating material and a second layer of conductive material which is the raised conductive circuit pattern, whereby the second layer of conductive material is located in the laminate insulating material and is exposed but recessed from the surface of the insulating material.

An alternative method for fabricating the top board panel of the printed circuit board to provide for recessed component mounting pads includes as the first step the fabrication of a member having a raised conductive first circuit pattern extending from a first, or base, layer of conductive material. The first layer of conductive material may be a layer disposed on a substrate or this first layer of conductive material may simply be a conductive substrate. A raised conductive thin second circuit pattern is deposited on the first circuit pattern corresponding to the desired locations of component mounting pads, and a second layer of conductive material is deposited upon the second circuit pattern to further raise the conductive second circuit pattern above the general plane of the first circuit pattern. The raised conductive first and second circuit patterns and the second layer of conductive material on the first layer of conductive material are embedded within a uniform thickness of laminate insulating material with the surface of the second layer of conductive material being exposed. The second layer of conductive material is removed until the second circuit pattern is exposed, and a third layer of conductive material is deposited upon the exposed surface of the second circuit pattern to a thickness less than the thickness of the second layer of conductive material. The first layer of conductive material is separated from the substrate, and the first layer of conductive material is removed from the laminate insulating material, whereby the third layer of conductive material is embedded in the laminate insulating material and is exposed but recessed from the surface of the insulating material.

Reference is now made to the description of the preferred embodiments, illustrated in the accompanying drawings, in which:
Figures 1-9 illustrate, sequentially, the steps for fabricating one of the center board panels of the multilayer printed wiring board;
Figures 10-15 illustrate, sequentially, the steps for fabricating the other of the center board panels of the printed wiring board;
Figures 16-18 illustrate sequentially the manufacturing steps involved in joining the two center board panels of the printed wiring board fabricated in accordance with Figures 1-15;
Figures 19-21 illustrate the fabrication of the printed wiring board with additional board panels added;
Figures 22-26 illustrate sequentially the process for completing fabrication of the multilayer printed wiring board;
Figures 27-45 illustrate sequentially the steps involved in forming a board panel having plated pillar recessed pads which can be utilized for providing component mounting locations on the printed wiring board of this invention; and
Figures 46-54 illustrate sequentially an alternative method of forming the recessed solder pads illustrated in Figures 27-45.
Figures 55-56 illustrate an alternative method to depositing an initial layer of conductive material onto a substrate to initiate the printed circuit board fabrication.

The invention described in the present application will enable fine line boards to be produced using an additive process. The lines will be built up using a deposition process, such as electroplating, and since it is an additive process, the size of the lines will not be etched at all, thereby greatly increasing the dimensional integrity of the lines and spaces. The printed wiring board of the present invention has better circuit stability during lamination than those boards produced by prior art processes because the circuit traces are either anchored to an electirically conductive material such as copper or imbedded into the dielectric material separating the lines.

The fabrication of the multi layer printed wiring board of the present invention begins with the middle two layers, or board panels, of the printed wiring board, which are eventually laminated together, and then continues with the next outer layers or panels being laminated to the middle pair, and so on until the entire board is laminated together into a single structure.

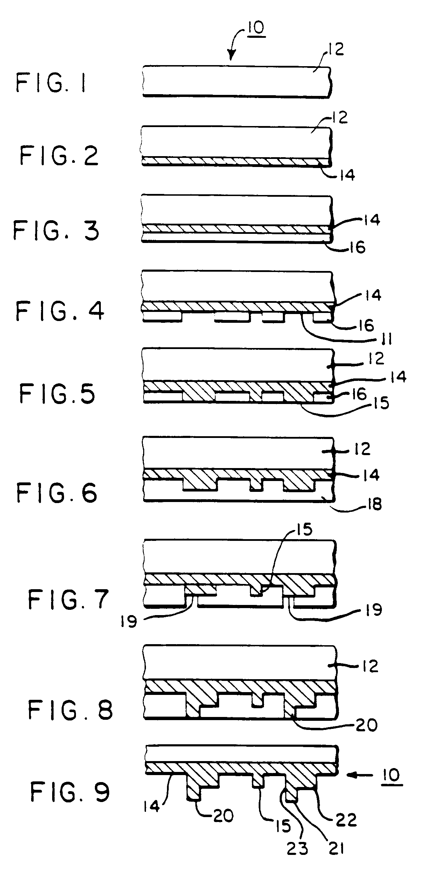

Referring now more particularly to Figures 1-9, therein is illustrated the sequential steps utilized in fabricating one of the middle layers, or board panels, of the multilayer board. The fabrication of the panel 10 requires that it be formed with one or more interlayer connection members, or pillars 20 which, as to be explained in greater detail herein, are utilized to provide electrical connection between the various panels. The fabrication of the panel 10 begins with a temporary substrate 12 (Figure 1) made of a material such as reusable type 304 stainless steel plate with a 2B finish. The plate 12 would typically be 0.190 cm (0.075 inches) thick and be mechanically and chemically cleaned.

The first step in the manufacture of the panel 10 is to deposit, by a process such as electroplating, a uniform thin first layer 14 of an electrically conducting, hereafter referred to for simplicity as conductive, material such as copper on the substrate 12 so as to form a layer of approximately 0.001 cm (0.0004 inches) of copper over the entire substrate 12. Note that although other known methods of deposition such as electroless chemical processes or spraying processes including sputtering, evaporation and ion deposition are available, electroplating is a preferred method of deposition. The copper layer 14 serves as a base layer, also known as a flash layer, upon which further electroplating of conductor lines may be applied, and also serves as a releasing material for separating the printed circuitry from the stainless steel substrate 12 after formation of the panel 10 is complete.

The copper layer 14 is then coated with a photosensitive resist layer 16 (Figure 3) of a material such as that sold under the trademark DuPont Riston. The next step (Figure 4) is to mask the photoresist 16 with a first photomask of the circuit pattern desired to be impressed upon the layer 14, and then the photoresist 16 is exposed to ultraviolet light, preferably from a collimated light source. The photoresist 16 is then developed away where the circuit pattern was, forming three-dimensional cavities 11 in the resist 16 and exposing the layer 14. The panel 10 is then plated (Figure 5) utilizing a deposition process such as electroplating to form a second layer 15 of conductive material such as copper upon the exposed portions of the first layer 14 of conductive material to form a raised conductive first circuit pattern above the general plane of the conductive layer 14 conforming to the three-dimensional cavity definition of the photosensitive resist 16 image.

After this step has been completed, the panel 10 is ready for further processing to fabricate the interlayer connection members. As illustrated in Figure 6, the panel 10, and more particularly the second layer 15 of copper, is coated with a layer 18 of photosensitive resist. The photoresist 18 is then masked with a second photomask to define a conductive second circuit pattern on the surface of the resist 18 corresponding to the desired locations of the interlayer connection members. The photoresist 18 is then exposed to light, and the resist 18 is dissolved away (Figure 7) to form three-dimensional cavities 19 in the resist 18 and exposing the second layer 15 according to the second circuit pattern. A third layer 20 of conducting material such as copper is then deposited (Figure 8), by a process such as electroplating, on the second layer 15 to provide a raised conductive second circuit pattern above the general plane of the second layer 15 conforming to the three-dimensional cavity 19 image of the photosensitive resist 19 image. This third layer 20 of conductive material is the interlayer connection member, or pillar, which is utilized to provide electrical connection between the circuitry of the panel 10 and the panel 30 to which it is to be connected.

After the pillars 20 have been fabricated to the desired thickness, the panel 10 is prepared for lamination (Figure 9). The photoresist 18 is removed from the panel 10 utilizing a stripping solution, thereby exposing top 21 and sidewall 23 surface portions of the raised first and second circuit patterns. This panel 10 is now ready to be laminated to form a section of the multilayer printed wiring board.

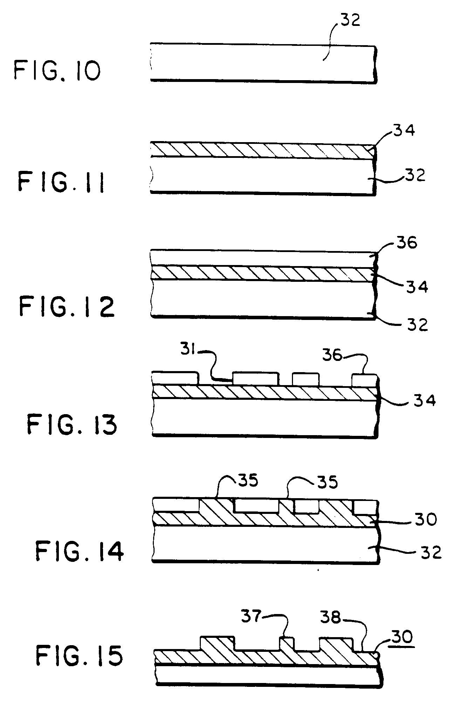

Figures 10-15 illustrate sequentially the steps that may be utilized for making a second board panel 30 of the printed wiring board. The second panel 30, which can be laminated to the first panel 10 to form the center pair of panels of the multilayered board, differs from the fabrication of the first panel 10 in that the pillars 20 are not required if the panel 30 is to be laminated to the panel 10.

The fabrication of the panel 30 begins with a temporary substrate 32 (Figure 10) made of a material such as reusable type 304 stainless steel plate with a 2B finish. The plate 32 would typically be 0.190 cm (0.075 inches) thick and be mechanically and chemically cleaned.

The first step in the manufacture of the panel 30 is to deposit, by a process such as electroplating, a uniform thin first layer 34 of a conductive material such as copper on the substrate 32 so as to form a layer of approximately 0.001 cm (0.0004 inches) of copper over the entire substrate 32 (Figure 11). Note that although other known methods of deposition such as electroless chemical processes or spraying processes including sputtering, evaporation and ion deposition are available, electroplating is a preferred method of deposition. The copper layer 34 serves as a base layer upon which further electroplating of conductor lines may be applied, and also serves as a releasing material for separating the printed circuitry from the stainless steel substrate 32 after formation of the panel 30 is complete.

The copper layer 34 is then coated with a photosensitive resist layer 36 (Figure 12) of a material such as that sold under the trademark DuPont Riston. The next step (Figure 13) is to mask the photoresist 36 with a photomask of the circuit pattern desired to be impressed upon the layer 34, and then the photoresist 36 is exposed to light, preferably from a collimated light source. The photoresist 36 is then developed away where the circuit pattern was, forming three-dimensional cavities 31 in the resist 36 and exposing the copper 34. The panel 30 is then plated (Figure 14) utilizing a deposition process such as electroplating to form a second layer 35 of conductive material such as copper upon the exposed portions of the first layer 34 of conductive material to form a raised conductive circuit pattern above the general plane of the conductive layer 34 conforming to the three-dimensional cavity definition of the photosensitive resist 36 image.

The photoresist 36 is removed from the panel 30 utilizing a stripping solution, thereby exposing top 37 and sidewall 38 surface portions of the raised circuit patterns. This panel 30 is now ready to be laminated to form a section of the multilayer printed wiring board.

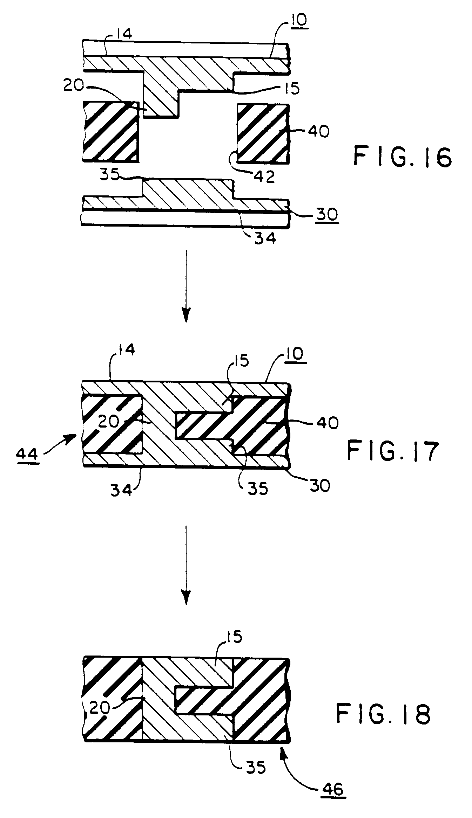

Referring now more particularly to Figures 16-18, there is illustrated the sequential steps utilized for joining, through lamination, the first and second middle panels 10, 30 respectively. In Figure 16, an epoxy glass laminate insulating material 40 has a plurality of openings 42 therethrough which correspond with the location of the pillars 20 of the panel 10. The panels 10, 30 are disposed adjacent to each other and aligned with each other such that the circuit patterns 15 and 20 on panel 10 and the circuit pattern 35 on panel 30 face each other, with the epoxy glass laminate insulating material 40 being disposed therebetween. As shown in Figure 17, this structure of panels 10, 30 and dielectric 40 are then laminated together to form a unitary structure 44, which if so desired can be a complete printed circuit board. Electrical connection between circuit pattern 15 and circuit pattern 35 is provided through the solid interlayer connection member 20, which was formed integrally bonded to layer 15 and which electrically contacts the layer 35, at least at selected portions thereof. The temporary substrates 12,32 are then separated from the layers 14,34 respectively to form the unitary structure 44.

This unitary structure 44 is then subjected to an etching process (Figure 18) to remove the first layers of conductive material 14, 34, resulting in a unitary structure 46 which can be either an entire board, or can be the innermost panel pair of a larger printed circuit board. This structure 46 includes only the circuitry 15, 35 of the original two panels 10,30 together with the solid interconnecting pillar 20 which provides electrical connection between the circuitry 15, 35. The dielectric material 40 is utilized to prevent electrical contact between the circuitry 15, 35 except at the locations of the interconnecting pillars 20.

It should be noted that the circuitry 15, 35 is held fixed within the dielectric on three sides thereof, which results in no movement of the circuitry and permits greater accuracy when interconnecting additional layers thereto. It also should be noted that the conductive circuit patterns 15,35 are exposed and lay flush and coplanar with the surface of the laminate insulator material 40, with uniform cross-section thickness across the entire structure 46.

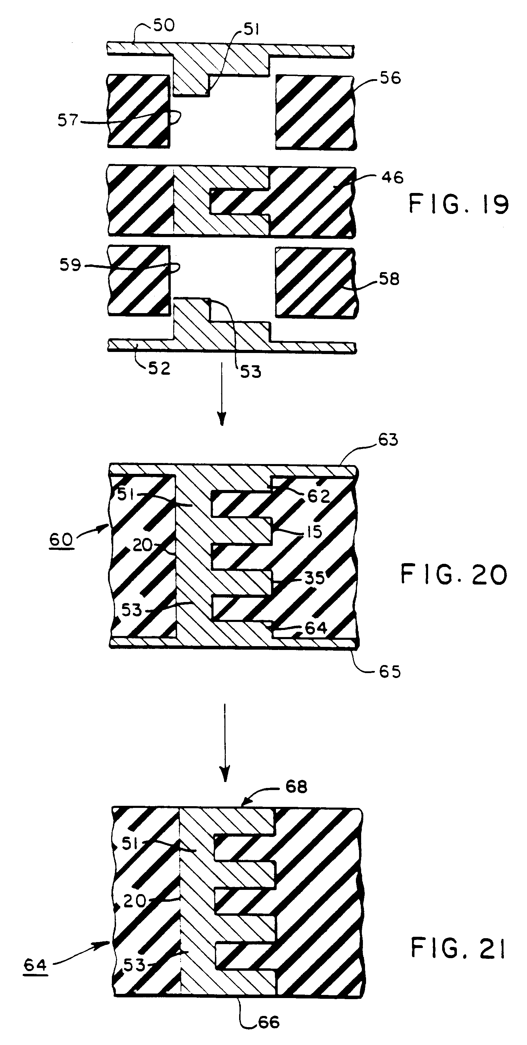

Figures 19-21 describe in greater detail how additional panels would be connected to the middle structure 46 illustrated in Figure 18. In Figure 19, additional panels 50 and 52 would be fabricated utilizing the process described in Figures 1-9, including circuitry patterns 62, 64 and the pillars 51, 53 as the interlayer connection members corresponding to the pillar 20 in Figure 9. The middle structure 46 would then be sandwiched between the upper panel 50 and the lower panel 52, separated by the laminate insulating materials 56, 58 with their aligned holes 57, 59 respectively therein. This entire sandwiched package is then laminated, as in Figure 20, to provide a unitary structure 60 in which multiple circuitry patterns 62, 15, 35, 64 are electrically interconnected by the pillars 51, 20, 53. The final step at this time is, similarly to that previously described, to remove the excess copper flash 63, 65 by an etching process to provide a multilayered printed wiring board structure 64 encased in dielectric insulating material and exposed only at the outer surfaces 68, 66 thereof. Furthermore, the interconnecting pillars 51, 20, 53 are solid copper members which insure electrical connection without the necessity of drilling holes in attempting to electroplate the interior thereof.

As can be readily appreciated, the process can continue as described for as many panels as are desired. During each lamination process, the outermost panels are laminated to the previously laminated internal structure, with all electrical connections between layers taking place through solid interlayer connection members corresponding to the pillars 20, 51 53.

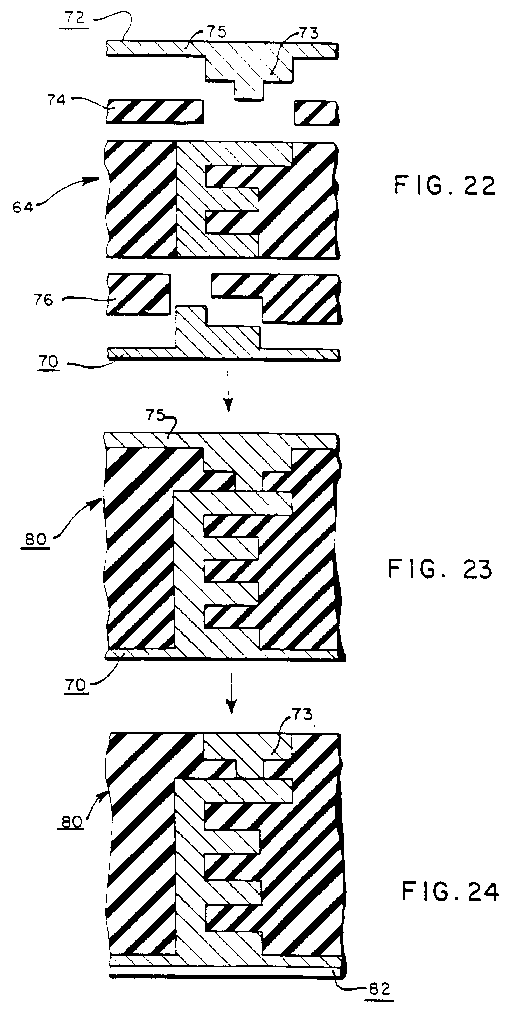

Referring now to Figures 22-26, therein is illustrated how the final two panels would be laminated to the completed structure 64. Typically, the final bottom panel 70 would be fabricated similarly to that described in Figures 1-9. The top panel 72 would similarly be fabricated, except that this panel 72 would generally not contain circuitry but instead would comprise only the pads 73 that would be utilized for soldering the component to be mounted to the circuitry, although if desired circuitry could, of course, be included within the panel 72.

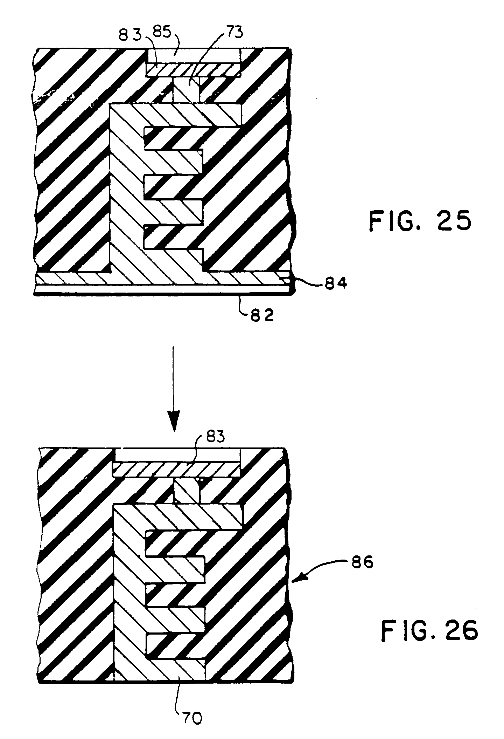

Similarly to the manufacturing process described above, the interior structure 64 is sandwiched between additional dielectric laminate insulating material 74, 76, and the outer panels 70, 72. As shown in Figure 23, these panels and laminate are laminated to each other to form a unitary structure 80. In Figure 24, the lower most panel 70 is covered with a protective mask 82, and the copper flash 75 is removed from the upper panel 72. The panel 72, containing the component mounting pad 73, is then etched and exposed to provide a recessed pad 73 for the mounting of the components (Figure 25). This recessed pad 73 then has deposited upon it, and completely or partially filling the recess 85, a predetermined amount of solder material 83 until it is at or below the level of the remainder of the surface of the board. After this step, the etch mask 82 is removed and the copper flash 84 is etched and removed from the panel 70. After this step, as illustrated in Figure 26, there exists a completed multilayer printed wiring board 86.

A printed wiring board as manufactured according to the fabrication steps herein described has many fundamental advantages that permit it to be utilized in the assembly of advanced VLSI circuits. The interlayer connections formed require less surface area on each layer than those formed in the prior art, resulting in the ability to fabricate denser circuitry. Furthermore, these solid interlayer connectors are less susceptible to cracking during temperature stressing than the conventional plated throughhole interconnectors. The manufacturing process, as described, can provide for the formation of recessed component mounting pads. The circuitry lines and spaces and interconnections are imbedded in a dielectric material giving higher precision and stability during fabrication, and the surface of the printed wiring board is smooth for easier assembly.

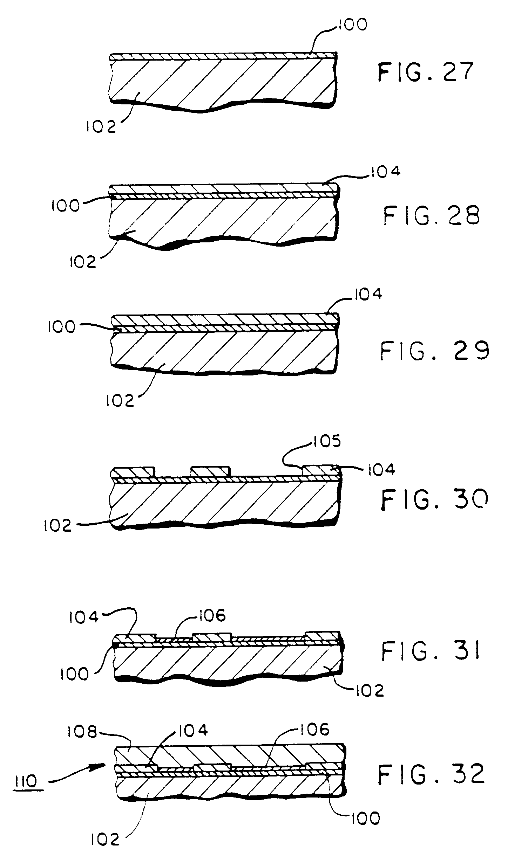

While the pad mounting panel 72 described above is preferable, an alternative method of fabricating this panel may be utilized. A method of independently fabricating this top, component mounting panel is sequentially illustrated in Figures 27-45.

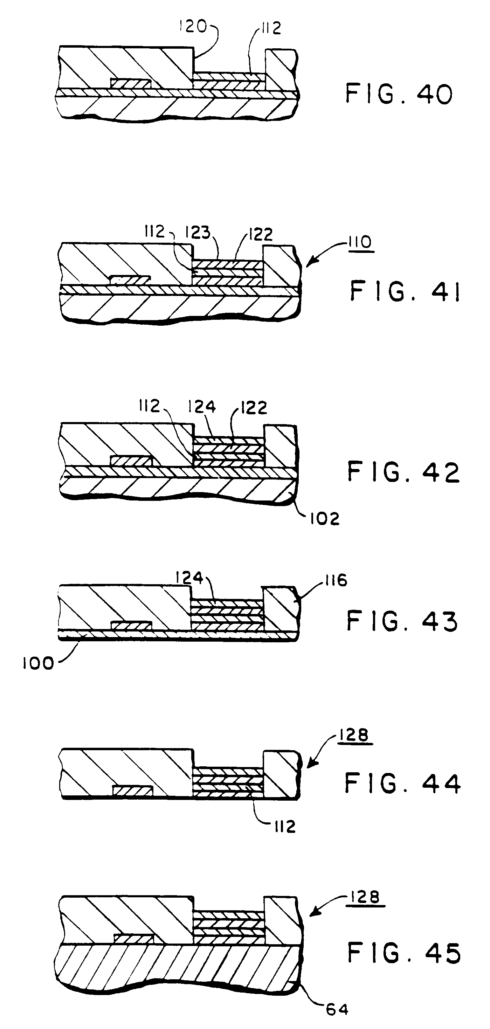

The fabrication of the panel 128 (Figure 45) begins with a temporary substrate 102 (Figure 27) made of a material such as reusable type 304 stainless steel plate with a 2B finish. The plate 102 would typically be 0.190 cm (0.075 inches) thick and be mechanically and chemically cleaned.

The first step in the manufacture of the panel 128 is to deposit, by a process such as electroplating, a uniform thin first layer 100 of a conductive material such as copper on the substrate 102 so as to form a layer of approximately 0.001 cm (0.0004 inches) of copper over the entire substrate 102. Note that although other known methods of deposition such as electroless chemical processes or spraying processes including sputtering, evaporation and ion deposition are available, electroplating is a preferred method of deposition. The copper layer 100 serves as a base layer upon which further electroplating may be applied, and also serves as a releasing material for separating the printed circuitry from the stainless steel substrate 102 after formation of the panel 128 is complete.

The copper layer 100 is then coated with a photosensitive resist layer 104 (Figure 28) of a material such as that sold under the trademark DuPont Piston. The next step (Figure 29) is to mask the photoresist 104 with a first photomask of the circuit pattern desired to be impressed upon the layer 100, and then the photoresist 104 is exposed to ultraviolet light, preferably from a collimated light source. The photoresist 104 is then developed away where the circuit pattern was, forming three-dimensional cavities 105 (Figure 30) in the resist 104 and exposing the layer 100. The panel 128 is then plated (Figure 31) utilizing a deposition process such as electroplating to form a second layer 106 of conductive material such as copper upon the exposed portions of the first layer 100 of conductive material to form a raised conductive first circuit pattern above the general plane of the conductive layer 100 conforming to the three-dimensional cavity definition of the photosensitive resist 104 image.

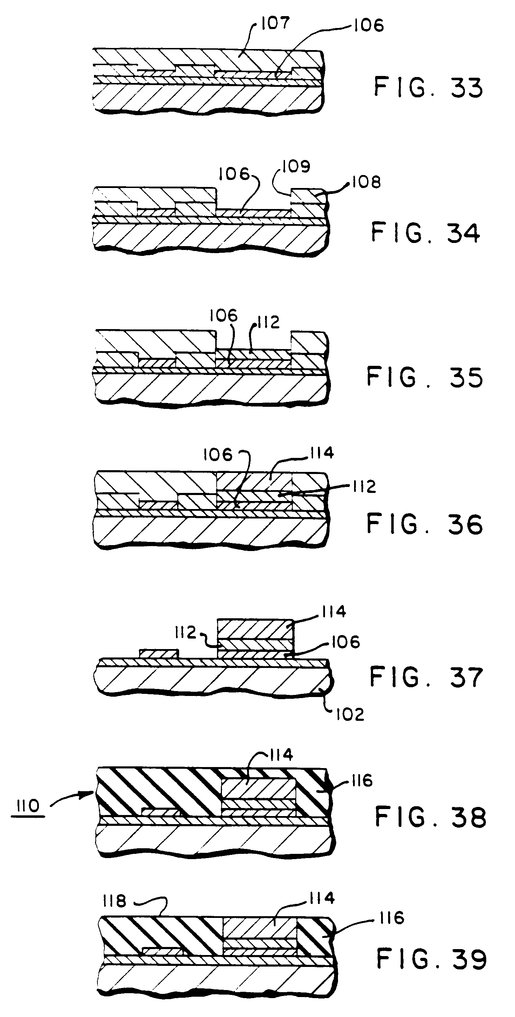

After this step has been completed, the panel 110 is ready for further processing to fabricate the component mounting locations or pads. As illustrated in Figure 32, the panel 110, and more particularly the second layer 106 of copper, is coated with a thick layer 108 of photosensitive resist. The photoresist 108 is then masked (Figure 33) with a second photomask to define a conductive second circuit pattern on the surface of the resist 108 corresponding to the desired locations 107 of the component mounting pads. The photoresist 108 is then exposed to light, and the resist 108 is dissolved away (Figure 34) to form three-dimensional cavities 109 in the resist 108 and exposing the second layer 106 according to the second circuit pattern and the desired component mounting pad locations 107.

A thin third layer 112 of conductive material is deposited (Figure 35), by a process such as electroplating, upon the exposed portions 107 of the second layer of copper 106 to form a raised conductive second circuit pattern above the general plane of the second conductive layer 106. This thin third layer 112 should be of an electrically conducting material different from the copper material of the second layer 106, such as nickel. This nickel coating 112 will act as an etch resist subsequently in the process, and should be therefore, for example, approximately 0.0005 - 0.0008 cm (.0002 to 0.0003 inches) thick.

After the nickel coating 112 is applied, a fourth layer 114 of electrically conducting material such as copper is deposited (Figure 36), preferably by a process such as electroplating, upon the nickel layer 112 to further form the raised conductive second circuit pattern above the general plane of the third conductive layer 112 conforming to the three-dimensional cavity definition 109 of the photosensitive resist 108 image. The copper plating 114 utilized in this step will be subsequently removed to form the recessed component mounting pads.

In Figure 37, it is illustrated that all of the photoresists 108 is stripped and removed, with the result that the stainless steel substrate 102 now has a layer of copper 114 separated from the second layer 106 of circuitry by a nickel flash layer 112. The entire panel 110 is then laminated (Figure 38) with an epoxy glass dielectric laminate insulating material 116 to the desired thickness. The surface 118 of the dielectric material 116 is then sanded (Figure 39) so that the surface 118 is level and the copper layer 114 is exposed. The exposed copper layer 114 is then etched away (Figure 40) down to the nickel coating 112, exposing the nickel layer 112 and resulting in a recess 120 in the surface 118 of the panel 110.

The recess 120 is now capable of having disposed therein a solder material to be used as the component mounting pad. Because the solder 122 will be plated to the nickel coating 112, the nickel 112 should be activated before the solder plating process occurs. This nickel activation can be accomplished by placing the panel 128 in a 25% hydrochloric solution for approximately one minute. After the nickel coating 112 has been activated, a layer 122 of solder is deposited, by a process such as electroplating, upon the exposed surface of the nickel layer 112 (Figure 41). This solder layer 122 should be of a thickness less than the thickness of the etched copper layer 114 so that the level of the solder layer 122 is below the surface 118 of the laminate 116, resulting in a recessed component mounting pad 123. A flash layer of copper 124 is deposited (Fig. 42), using a process such as electroplating, upon the solder layer 122 as a protective layer and may be removed at any time.

The stainless steel substrate 102 is removed (Figure 43) and separated from the first conductive layer 100 and its raised first and second circuit patterns. The copper layer 100 is then etched away (Figure 44) from the laminate insulating material 116, resulting in one complete panel 128 which can then be laminated (Figure 45) as the top layer of a multilayered printed wiring board 64. Electrical interconnection between this panel 128 and the remaining board 64 can be accomplished either by the use of conventional plated through holes or by the addition of the plated pillars previously described.

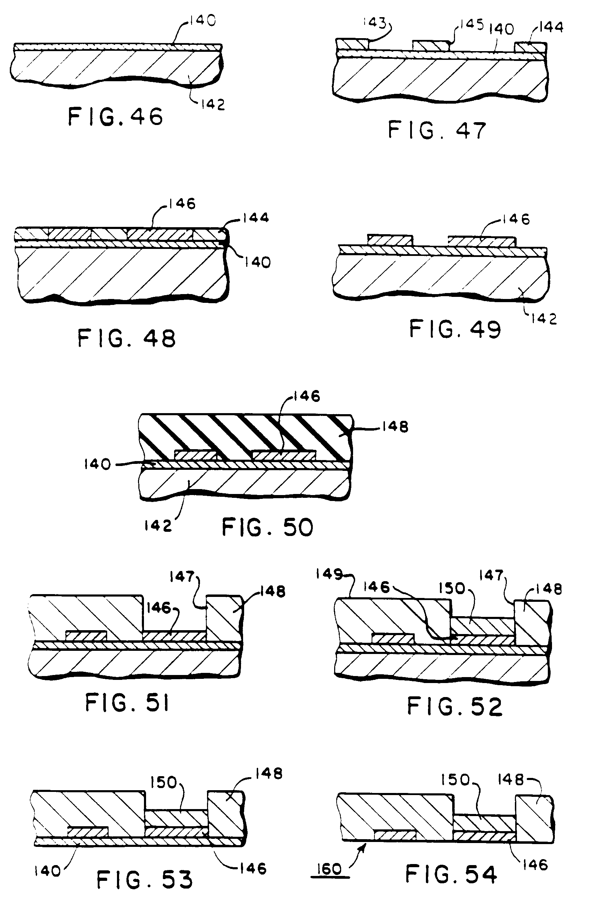

An alternative method for fabricating the top layer 72 of the wiring board, with its recessed component mounting pads, is illustrated in Figures 46-54. Similarly to the process described with respective Figures 27-45, the fabrication of the panel 160 begins with a temporary substrate 142 (Figure 46) made of a material such as reusable type 304 stainless steel plate with a 2B finish. The substrate 142 would typically be 0.190 cm (0.075 inches) thick and be mechanically and chemically cleaned.

The first step in the manufacture of the panel 160 is to deposit, by a process such as electroplating, a uniform thin first layer 140 of a conductive material such as copper on the substrate 142 so as to form a layer of approximately 0.001 cm (0.0004 inches) of copper over the entire substrate 142. Note that although other known methods of deposition such as electroless chemical processes or spraying processes including sputtering, evaporation and ion deposition are available, electroplating is a preferred method of deposition. The copper layer 140 serves as a base layer upon which further electroplating may be applied, and also serves as a releasing material for separating the printed circuitry from the stainless steel substrate 142 after formation of the panel 160 is complete.

The copper layer 140 is then coated with a photosensitive resist layer 144 (Figure 47) of a material such as that sold under the trademark DuPont Riston, masked with a first photomask of the circuit pattern desired to be impressed upon the layer 140, including selected positions 145 where component mounting pads are to be locate, and then the photoresist 144 is exposed to light, preferably from a collimated light source. The photoresist 144 is then developed away where the circuit pattern was, forming three-dimensional cavities 143,145 in the resist 144 and exposing the copper 140. A second layer 146 of conductive material such as copper is deposited, by a process such as electroplating, upon the exposed portions of the first layer 140 of conductive material (Figure 48) to form a raised conductive first circuit pattern above the general plane of the conductive first layer 140 conforming to the three-dimensional cavity definition of the photosensitive resist 144 image. The remaining photoresist 144 is then stripped and removed (Figure 49).

The raised circuit layer 146 is then embedded within a laminate insulating material 148 (Figure 50) having a thickness greater than the height of the raised circuit layer. The laminate insulating material 148 is then removed from those selected areas 147 above the second conductive layer 146 (Figure 51) corresponding to the locations of the component mounting pads, preferably utilizing laser drilling. Using either a ruby laser or a carbon dioxide laser (not shown), it is possible to burn away the laminate insulating material 148 without affecting the copper layer 146 other than to expose it for further processing.

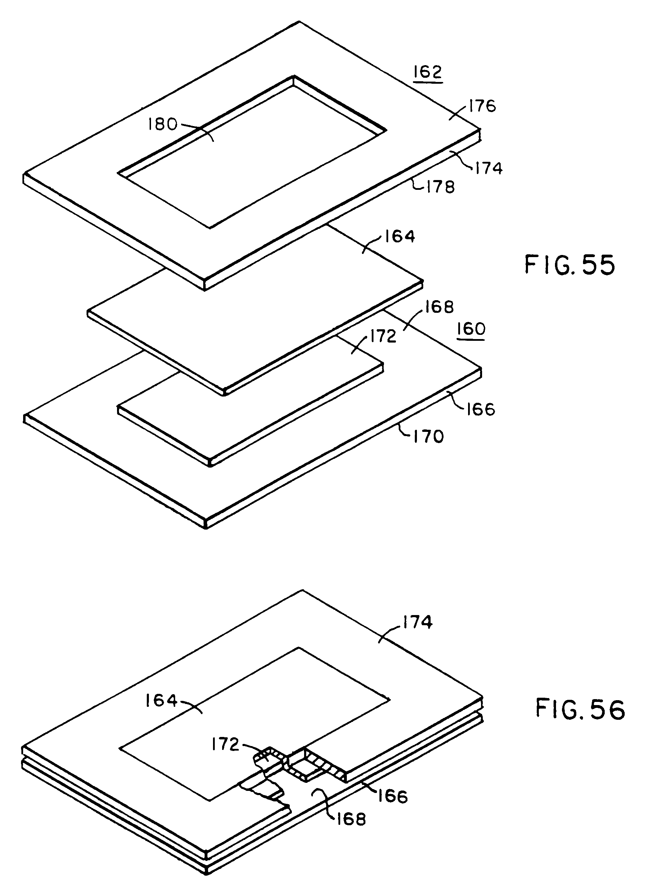

Once the laminate material 148 is removed from the area 147 above the layer 146, a layer 150 of solder is deposited (Figure 52), preferably by a process such as eletroplating, upon the exposed surfaces of the second layer 146 of conductive material to a thickness less than the thickness of the laminate insulating material 148 above the second layer 146 so that the solder layer 150 will be recessed from the top surface 149 of the laminate material. The thin copper layer 140, with the circuitry 146, component mounting pads 150 and the epoxy 148 is then removed from the stainless steel substrate (Figure 53). Finally, the copper flash layer 140 is etched away (Figure 54), leaving circuitry 146 imbedded in an epoxy laminate insulating material 148 with solder pads 150 recessed in the laminate 148. This top panel 160 can then be laminated to the remainder of the multilayer printed wiring board. Electrical interconnection between this panel 160 and the remaining board can be accomplished either by the use of conventional plated through holes or by the addition of the plated pillars previously described.

Note that throughout the discussion the fabrication of each type of printed circuit board has been initiated using a foundational layer made by depositing a temporary flash layer of a conductive material such as copper upon a temporary substrate made of a material such as reuseable stainless steel plate. Circuitry was built up from this temporary flash layer. As a final step in preparing the printed circuit board, the stainless steel substrate was peeled away from the copper flashing and then the copper flashing was removed by etching the flashing from the printed circuit board. While copper is used for the flash layer and stainless steel is used for the substrate in the discussion, other materials may be used. One of other possible combinations includes an aluminum substrate used in lieu of a stainless steel substrate with flashing deposited upon this.

While a substrate having a deposited flash layer is one preferred technique, this invention should not be limited to using only this type of a foundational layer.

One alternative to this involves the use of a thin foil of an electrically conducting material mechanically clamped to a frame. This combination serves as a substitute for a flash layer deposited upon a substrate. The circuitry is deposited directly upon this thin foil. One embodiment comprises a two-part frame 160 and 162 (Figure 55) used to clamp the thin foil 164 such that circuitry may be deposited directly upon the foil 164. This deposition is in lieu of deposition of a layer of conductive material upon a substrate so that this foil may be used as the base layer in the fabrication of a printed circuit board. Both parts 160 and 162 of the frame are made of a lightweight, semi-flexible material such as polyimide. Fiber reinforced polyimide board may be used. The first part 160 of the frame is a generally flat rectangular plate 166 having a thickness of about 0.102 cm (0.040 inches) with an top surface 168 and a bottom surface 170. From the top surface 168 extends a raised flat platform 172. The platform 172 is approximately the shape of the the printed circuit board to be fabricated.

The second part 162 of the frame is a generally flat rectangular plate 174 having a thickness of about 0.102 cm (0.040 inches), similar in shape to plate 166, with an top surface 176 and a bottom surface 178. The plate 174 has an opening 180 slightly larger than, although similar in shape to, the platform 172.

The thin foil 164, which has a thickness of about 0.003 cm (0.001 inches), is placed between the two-part frame and the parts 160 and 162 are positioned parallel to one another such that the raised platform 172 is aligned with the opening 180. The parts 160 and 162 are then mechanically clamped together such that the top surface 168 of plate 166 compresses the foil 164 against the bottom surface 178 of plate 174, thereby forcing the raised platform 172 through the opening 180 and also forcing that portion of the foil 164 contacted by the raised platform 172 to protrude through the opening 180, as shown in Figure 56. Note that for this reason the thickness of the platform 172 must be adequate for the platform 172 to penetrate the opening 180 so that the foil is at least flush with the top surface 176 of the plate 174. In this situation the platform 172 should be at least 0.102 cm (0.040 inches) thick, which is the thickness of the plate 174. Although not shown note that for ease of alignment of the two frame parts, registration holes may be drilled through one part for visual alignment with markers placed on the other part.

Just as circuitry is deposited directly upon the layer of conductive material on a substrate described in an earlier embodiment in this document, circuitry is deposited directly upon the framed thin foil and a printed circuit board is built up from this. After the printed circuit board is fabricated, the thin foil must be removed. This is easily done by disassembling the frame parts 160 and 162 and removing the foil 164 through etching. By design the opening 180 in plate 164 is large enough to fit around the printed circuit board when the frame is disassembled. For this arrangement a preferred material for the foil is either copper or aluminum. In this manner a structure exists that may be used in lieu of a substrate.

In both metal deposition onto a substrate and fixation of a foil onto a frame, a preferred material for the circuit lines which are deposited onto the flash layer or the foil is copper. Other conductive materials that may be used include nickel and gold.

Still another alternative for this invention involves the use of a substrate made of an electrically conducting material such that circuitry may be electroplated directly upon this substrate without an intermediate flash layer and the substrate may also be easily removed to expose the circuit lines. In order for this approach to be successful the substrate must be made of a different material than the circuit lines such that the substrate may be etched away with a selected etchant that will attack the substrate material but will not attack the circuit lines, thereby preserving the quality and dimensions of the circuit lines. The selection of an etchant that will attack the substrate material but will not attack the circuit lines would be obvious to one skilled in the art.

While any number of conductive pairs may be used as substrate/circuit line materials, one preferred combination is copper for the circuit lines electroplated onto an aluminum substrate. In this situation the surface of the aluminum substrate must first be treated with an alkaline, aqueous, alkali metal zincate treating bath to promote adhesion between the aluminum substrate and the circuit lines.

Treating an aluminum surface with a zincated solution to increase adhesion is a process well known in the art. Such zincate baths, as described in U.S. Pat. Nos.2,676,916 and 2,650,886, contain an alkali metal hydroxide, zinc oxide, a water soluable metal salt, such as a salt of iron; cobalt or nickel, and a complexing agent for the metal ions introduced as the water soluable metal salt, such as Rochelle salt, a tannate, or a sugar.

Other material combinations compatible with this process include the use of nickel or gold for the circuit lines electroplated onto a copper substrate although in these instances a zincate bath is not necessary.

Throughout this discussion panels have been laminated together to form printed circuit boards. A preferred method of lamination is through thermal compression which involves compressing two panels, such as panels 10 and 30 in Figure 16, against a laminating insulating material, such as 40, under sufficient pressure and temperature to form a bond not only between the panels and the laminating material, but also to form a bond between the two panels 10 and 30 such that the interconnect member 20 bonds to the layer 35. The temperature and pressure for this thermal compression technique for lamination would be known to one skilled in the art.

When the circuitry is copper, the thermal compression bonding between the interconnect member of one panel and the layer of another panel may be enhanced through the deposition, preferable by electroplating, of a thin layer of gold having a thickness of approximately 0.001 cm (0.0004 inches) upon the surface of the interconnect member that contacts the layer. This would require an additional deposition step following the deposition of the interconnect member involving a similar process but only depositing a different material. This additional deposition step would not be required if the circuitry is either gold or nickel.

Thus, what has been described is an improved multilayer printed wiring board which utilizes solid plated interconnections for the various layers and which can be fabricated with very detailed lines and spaces to provide a compact wiring board for very large scale integrated circuit requirements. The outer layer of the printed wiring board further is provided with recessed mounting pads to which the leads of the attached components can be mounted by using a vapor phase soldering process without incurring the problem of solder bridging between the various pads.

## Claims

1. A method for fabricating a multilayer printed circuit board comprising the steps of:
a) providing a first board panel (30) having a uniform first layer of conductive material (34) and a raised electrically conducting first circuit pattern (35) extending from the first layer of conductive material, the first layer of conductive material having structural reinforcement (32) such that the first circuit pattern (35) may be deposited directly upon the first layer surface, and the first layer further of a conductive material different than that of the circuit pattern, such that a selected etchant will attack only the first conductive layer material;
b) providing a second board panel (10) having a uniform second layer of conductive material (14) and a raised electrically conducting second circuit pattern (15) extending from the second layer of conductive material and a raised electrically conducting third circuit pattern (20) extending from said second circuit pattern, the second layer of conductive material (15) having structural reinforcement (12) such that the second circuit pattern (15) may be deposited directly upon the second layer surface, and the second layer further of a conductive material different than that of the circuit pattern, such that a selected etchant will attack only the second layer material;
c) uniting a plurality of conductive circuit pattern assembly board panels while cavernous fill-laminating said first board panel (30) matched to said second board Panel (10) with a laminate insulating material (40) being the filling disposed in the caverns or cavities formed therebetween and thereby electrically insulating said first circuit pattern (35) from said second circuit pattern (15) and with said third circuit pattern (20) electrically contacting said first circuit pattern (35) at selected portions thereof; and then
d) etching away said first and second layers of conductive material (14, 34) from said laminate insulating material and away from said first and second circuit patterns.

2. The method of claim 1 wherein:
a) the conductive material of the first and second layers of conductive material (14, 34) is copper on a structural reinforcement (12, 32) of either treated aluminum or copper; and
b) the conductive material used to form the conductive circuit patterns is a metal selected from the group consisting of copper, nickel, tin and gold.

3. The method in claim 1 wherein:
a) the conductive material of the first and second conductive layers (14, 34) is copper; and
b) the conductive material used to form the conductive circuit patterns is a metal selected from the group consisting of copper, nickel, tin and gold.

## Patentansprüche

1. Verfahren zur Herstellung einer gedruckten Mehrschicht-Leiterplatte, die die folgenden Schritte umfasst:
a) es wird eine erste Schalttafel (30) mit einer gleichförmigen ersten Schicht aus leitendem Material (34) und einem erhöhten elektrisch leitenden ersten Schaltmuster (35) geliefert, die sich von der ersten Schicht aus leitendem Material erstreckt, mit strukturellen Verstärkungen (32), so dass das erste Schaltmuster (35) direkt auf der Oberfläche der ersten Schicht abgelagert werden kann, und die erste Schicht weiterhin aus einem von dem des Schaltmusters verschiedenen Material besteht, so dass ein ausgewähltes Ätzmittel nur das erste leitende Schichtmaterial angreift;
b) es wird eine zweite Schalttafel (10) mit einer gleichförmigen Schicht aus leitendem Material (14) und einem erhöhten elektrisch leitenden zweiten Schaltmuster (15) geliefert, das sich von der zweiten Schicht aus leitendem Material erstreckt, und einem erhöhten elektrisch leitenden dritten Schaltmuster (20), das sich von dem zweiten Schaltmuster erstreckt, wobei die zweite Schicht aus leitendem Material (15) strukturelle Verstärkungen (12) hat, so dass das zweite Schaltmuster (15) direkt auf der Oberfläche der zweiten Schicht abgelagert werden kann, und die zweite Schicht weiterhin aus einem leitenden Material besteht, dass von demjenigen des Schaltmusters verschieden ist, so dass ein ausgewähltes Ätzmittel nur das zweite leitende Schichtmaterial angreift;
c) eine Vielzahl von leitenden Schaltmusteranordnungsschalttafeln wird vereinigt, während die erste Schalttafel (30) porös ausgefüllt wird, angepasst an die zweite Schalttafel (10) mit einem Schichtstoffisoliermaterial (40), das das Füllmittel ist, das in den dazwischen gebildeten Höhlen oder Hohlräumen angeordnet ist und dabei das erste Schaltmuster (35) elektrisch von dem zweiten Schaltmuster (15) an ausgewählten Stellungen elektrisch berührt; und dann
d) werden die ersten und zweiten Schichten aus leitendem Material (14, 34) von dem Schichtstoffisoliermaterial und von den ersten und zweiten Schaltmustern abgeätzt.

2. Verfahren nach Anspruch 1, in dem
a) das leitende Material der ersten und zweiten Schichten aus leitendem Material (14, 34) Kupfer auf einer strukturellen Verstärkung (12, 32) aus entweder behandeltem Aluminium oder Kupfer ist; und
b) das leitende Material, das zur Bildung der leitenden Schaltmuster benutzt wird, ein Metall ist, das von der Gruppe, die aus Kupfer, Nickel, Zinn und Gold besteht, ausgewählt wird.

3. Verfahren nach Anspruch 1, in dem
a) das leitende Material der ersten und zweiten leitenden Schichten (14, 34) Kupfer ist; und
b) das leitende Material, das zur Bildung der leitenden Schaltmuster benutzt wird, ein Metall ist, das von der Gruppe, die aus Kupfer, Nickel, Zinn und Gold besteht, ausgewählt wird.

## Revendications

1. Procédé de fabrication d'une carte de circuit imprimé multicouche, comprenant les étapes suivantes :
a) préparation d'une première plaquette (30) de carte comportant une première couche uniforme de matériau conducteur (34) et un premier motif de circuit (35) électroconducteur, en relief, partant de la première couche de matériau conducteur, la première couche de matériau conducteur comportant un renfort (32) structural tel que le premier motif de circuit (35) peut être déposé directement sur la surface de la première couche, et la première couche étant en outre en un matériau conducteur différent de celui du motif de circuit, de sorte qu'un réactif de gravure chimique sélectionné va n'attaquer que le matériau de la première couche conductrice,
b) préparation d'une seconde plaquette (10) de carte comportant une seconde couche uniforme de matériau conducteur (14), un second motif (15) de circuit, électroconducteur et en relief, partant de la deuxième couche de matériau conducteur, et un troisième motif (20) de circuit, électro-conducteur et en relief, partant dudit second motif de circuit, la deuxième couche de matériau conducteur (14) comportant un renfort structural (12) tel que le second motif de circuit (15) peut être déposé directement sur la surface de la seconde couche, et la seconde couche étant en outre en un matériau conducteur différent de celui du motif de circuit, de sorte qu'un réactif de gravure chimique sélectionné va n'attaquer que le matériau de la seconde couche,
c) l'union d'une pluralité de plaquettes de carte d'un ensemble de motifs de circuits conducteurs par stratification, avec remplissage des vides, de la première plaquette de carte (30) appariée à ladite seconde plaquette de carte (10), un matériau (40) d'isolation du feuilletage constituant le remplissage placé dans les vides et les trous formés entre elles, et isolant ainsi électriquement ledit premier motif (35) de circuit dudit second motif (15) de circuit, ledit troisième motif (20) de circuit étant en contact électrique avec ledit premier motif (35) de circuit en des parties sélectionnées de celui-ci, puis
d) élimination par attaque chimique desdites première et seconde couches de matériau conducteur (14, 34) dudit matériau isolant de feuilletage et desdits premier et second motifs de circuit.

2. Procédé selon la revendication 1, dans lequel :
a) le matériau conducteur des première et seconde couches de matériau conducteur (14, 34) est du cuivre sur un renfort structural (12, 32) fait d'aluminium ou de cuivre traité, et
b) le matériau conducteur utilisé pour former les motifs de circuit conducteur est un métal choisi dans le groupe formé par le cuivre, le nickel, l'étain et l'or.

3. Procédé selon la revendication 1, dans lequel :
a) le matériau conducteur des première et seconde couches conductrices (14, 34) est du cuivre, et
b) le matériau conducteur utilisé pour former les motifs de circuit conducteur est un métal choisi dans le groupe formé par le cuivre, le nickel, l'étain et l'or.
